# FASCICULE DE BREVET EUROPEEN

(11) **EP 3 776 642 B1**
(45) Date de publication et mention de la délivrance du brevet: **11.05.2022**
(21) Numéro de dépôt: 19718788.3
(22) Date de dépôt: 22.03.2019
(51) Int. Cl.: H01L 21/762, H01L 21/822, H01L 27/06

(54) **PROCÉDÉ DE FABRICATION D'UN SUBSTRAT DONNEUR POUR LA RÉALISATION D'UNE STRUCTURE INTÉGRÉE EN TROIS DIMENSIONS ET PROCÉDÉ DE FABRICATION D'UNE TELLE STRUCTURE INTÉGRÉE**
VERFAHREN ZUR HERSTELLUNG EINES DONORSUBSTRATS ZUR HERSTELLUNG EINER DREIDIMENSIONALEN INTEGRIERTEN STRUKTUR UND VERFAHREN ZUR HERSTELLUNG EINER SOLCHEN INTEGRIERTEN STRUKTUR
METHOD FOR PRODUCING A DONOR SUBSTRATE FOR CREATING A THREE-DIMENSIONAL INTEGRATED STRUCTURE, AND METHOD FOR PRODUCING SUCH AN INTEGRATED STRUCTURE

(30) Priorité: 29.03.2018 FR 1852751
(43) Date de publication de la demande: 17.02.2021
(73) Titulaire: SOITEC, 38190 Bernin (FR)
(72) Inventeur: GAUDIN, Gweltaz, 38920 Crolles (FR); LANDRU, Didier, 38190 Champ Pres Froges (FR); GHYSELEN, Bruno, 38170 Seyssinet-Pariset (FR)
(74) Mandataire: Regimbeau
(86) Numéro de dépôt international: PCT/FR2019/050653
(87) Numéro de publication internationale: WO 2019/186035

(56) Documents cités:
- WO-A1-2013/045985
- WO-A1-2017/012940
- US-A1- 2016 197 006

## Description

### DOMAINE TECHNIQUE DE L'INVENTION

La présente invention concerne la fabrication d'un substrat dit « substrat donneur » pour la réalisation d'une structure intégrée en trois dimensions de type semi-conducteur sur isolant. L'invention se rapporte également à un procédé de fabrication d'une telle structure intégrée en trois dimensions, qui est formée d'un empilement de couches, et en particulier de couches munies de dispositifs électroniques, par transfert d'une couche du substrat donneur sur un second substrat, dit « substrat receveur ».

### ETAT DE LA TECHNIQUE

Une structure intégrée en trois dimensions, notamment de type semi-conducteur sur isolant, dite structure « semiconductor on insulator » (acronyme SeOI) en anglais, en particulier « silicon on insulator » (SOI) lorsque le matériau semi-conducteur est du silicium, comprend un empilement de plusieurs couches, dont en particulier des couches dans lesquelles sont formés des dispositifs ou circuits électroniques dites « couches actives ». Les procédés de fabrication de telles structures intégrées sont typiquement désignés en tant que procédés d'intégration en trois dimensions (3D).

Parmi les procédés d'intégration possibles, l'intégration 3D par transfert de couche d'un substrat donneur sur un substrat receveur se présente comme étant une solution prometteuse pour empiler des couches actives.

Conformément à ce type de procédé, on crée dans le substrat donneur une zone dite « de fragilisation » qui délimite une couche à transférer, on colle le substrat donneur sur le substrat receveur, puis on détache le substrat donneur le long de la zone de fragilisation, de manière à transférer la couche sur le substrat receveur.

Un procédé de transfert de couche bien connu est le procédé Smart Cut^{™}, dans lequel la zone de fragilisation est créée par implantation d'atomes d'hydrogène et/ou d'hélium dans le substrat donneur à une profondeur prédéterminée qui correspond sensiblement à l'épaisseur de la couche à transférer.

Le procédé Smart Cut^{™} est avantageux car il permet de réutiliser le substrat donneur après transfert de la couche pour d'autres applications ultérieures, et permet de transférer des couches minces de manière uniforme.

Des tentatives d'implantations d'ions à grande profondeur ont été réalisées afin de transférer, conformément au procédé Smart Cut^{™}, des couches actives de forte épaisseur, en augmentant l'énergie d'implantation. Cependant, plus l'énergie d'implantation est élevée, plus la quantité d'ions à implanter doit être élevée, et plus le courant d'implantation (densité de courant) est faible, ce qui aboutit à une augmentation des coûts de production et limite la faisabilité du procédé.

De plus, l'implantation ionique est réalisée par exposition de la face active du substrat donneur contenant les dispositifs électroniques au rayonnement ionique. Ce rayonnement cause des dommages aux dispositifs électroniques de la couche active, et il est donc nécessaire de prévoir des étapes additionnelles visant à réparer les dispositifs électroniques endommagés. Les dommages causés aux dispositifs électroniques sont d'autant plus importants que l'énergie d'implantation et la quantité d'ions à implanter sont élevées.

Pour conserver les propriétés électriques des dispositifs électroniques, il serait envisageable d'appliquer un budget thermique pour retirer l'hydrogène et activer le dopage. Cependant, dans ce cas, la température doit être supérieure à 700°C, ce qui n'est pas compatible avec la fabrication de structure 3D par empilement de couches actives. Il a été envisagé de réaliser une croissance par épitaxie en phase solide afin de diminuer le budget thermique. On peut ainsi arriver à une température légèrement supérieure à 525°C dans le cas d'une épitaxie du silicium, ce qui reste élevé. Il est possible de diminuer encore le budget thermique pour atteindre une température de l'ordre de 475°C, au détriment du temps de recuit thermique qui augmente alors très fortement et devient nettement supérieur à 24 heures, ce qui n'est pas compatible avec les cadences de production industrielles.

L'épaisseur totale des empilements des dispositifs électroniques en face avant et en face arrière sera limitée, puisqu'elle devra être inférieure à la profondeur de pénétration des ions. On se retrouve alors avec une épaisseur totale très faible, inférieure ou égale à environ 1 ou 2 micromètres, même lorsque les ions utilisés présentent un haut niveau d'énergie.

Par ailleurs, les couches à empiler comprennent des couches de silicium, mais également des couches diélectriques et métalliques. Réaliser une implantation ionique suffisamment profonde nécessite donc une énergie élevée et une très grande quantité d'ions implantée afin de permettre un bon détachement du substrat donneur ultérieurement. Or, étant donné que le courant d'implantation ionique peut décroitre de manière conséquente avec l'énergie, la durée de l'implantation ionique nécessaire au détachement du substrat donneur et au transfert d'une couche active est très élevée, ce qui est un inconvénient majeur à la réalisation d'un tel procédé.

Enfin, la profondeur d'implantation des ions dépend des caractéristiques physicochimiques des couches actives, qui peuvent plus ou moins freiner les ions lors de l'implantation ionique. Par exemple, les couches actives peuvent différer au niveau de l'agencement des couches métalliques qu'elles contiennent, certaines zones contenant du métal et d'autres non, ce qui influe sur le comportement des ions qui traversent ces zones des couches actives. Ceci aboutit à la formation d'une zone de fragilisation discontinue et ainsi à un mauvais détachement du substrat donneur le long cette zone de fragilisation.

D'autres techniques de transfert sont également utilisables.

Parmi celles-ci, l'empilement de puces de différentes fonctions ou « chip stacking » en terminologie anglo-saxonne, consiste à partir d'un substrat de faible épaisseur, à coller les puces sur le substrat en les empilant les unes sur les autres pour former une structure 3D puis d'interconnecter les puces et le substrat par des moyens prévus à cet effet tels que par câblage ou par utilisation de couches de silicium interposées entre deux puces. On obtient ainsi une structure 3D multifonctionnelle du fait des différentes fonctions des puces assemblées.

Le principal inconvénient de cette technique, outre son coût élevé, est que l'alignement des puces ainsi assemblées n'est pas optimal (typiquement <0.5µm, 200nm 3σ). Il est donc nécessaire de prévoir des contacts ou connexions entre les puces et le substrat possédant un diamètre élevé, ce qui résulte en des pertes électriques, et limite les possibilités d'intégration.

L'empilement séquentiel 3D, ou « 3D sequential stacking » en terminologie anglo-saxonne, consiste à transférer une couche de silicium sur une couche active afin de pouvoir fabriquer de nouveaux dispositifs électroniques sur ceux de la couche active sous-jacente. Dans ce cas, l'alignement des couches est seulement limité par la technique de lithographie employée, et peut être très précis, de l'ordre du nanomètre. Les différentes couches actives transférées formant la structure 3D sont ensuite interconnectées. Cette technique permet de réduire le nombre de couches de lithographie et de couches d'interconnexion comparées au « chip stacking » décrit précédemment.

Un inconvénient majeur de cette technique est que le procédé de fabrication des nouveaux dispositifs électroniques doit être compatible avec les caractéristiques de la couche active sous-jacente, notamment en préservant son intégrité, ce qui peut limiter les performances à la fois des nouveaux dispositifs électroniques et des dispositifs électroniques de la couche active sous-jacente.

L'empilement de dispositifs électroniques 3D, ou « 3D device stacking » en terminologie anglo-saxonne, est similaire à l'empilement séquentiel 3D décrit précédemment et permet d'obtenir un alignement des couches relativement précis et généralement inférieur au micromètre (typiquement <0.5µm, 200nm 3σ).

Un inconvénient de cette technique est que les couches actives empilées ne sont pas uniformes. L'utilisation d'un substrat donneur SOI permet cependant d'améliorer cette situation, mais au détriment de coûts additionnels. En outre, l'élimination (généralement par meulage) d'une partie du substrat donneur peut endommager les composants de la couche active du substrat receveur.

De plus, quelle que soit la nature du substrat donneur, celui-ci ne peut plus être réutilisé après la mise en œuvre du procédé puisqu'il a été partiellement meulé. Ceci constitue un inconvénient majeur des techniques connues, puisqu'il est nécessaire de changer de substrat donneur pour chaque transfert, ce qui a un impact financier conséquent en plus d'augmenter le temps de fabrication de la structure 3D.

Les documents WO 2013/045985 A1, WO 2017/012940 A1 et US 2016/197006 A1 décrivent différents procédés de l'art antérieur pour fabriquer un circuit intégré 3D.

### BREVE DESCRIPTION DE L'INVENTION

Un but de l'invention est de proposer un procédé de fabrication d'un substrat donneur pour la réalisation d'une structure intégrée en trois dimensions (3D), notamment de type semi-conducteur sur isolant, formée d'un empilement de couches munies de dispositifs électroniques, ainsi qu'un procédé de fabrication d'un telle structure intégrée par transfert d'une couche active d'un substrat donneur sur un substrat receveur, permettant de s'affranchir des contraintes expérimentales inhérentes aux procédés existants, notamment des procédés décrits précédemment.

Les procédés de fabrication proposés visent plus particulièrement à réaliser une structure 3D par empilement de couches actives munies de dispositifs électroniques, sans dégrader la structure et les propriétés mécaniques desdits dispositifs électroniques.

Les procédés proposés visent en outre à réaliser une structure 3D tout en permettant la réutilisation du substrat donneur pour transférer d'autres couches ou portions de couche active.

Les procédés proposés visent également à permettre le transfert de couches actives de grande épaisseur, c'est-à-dire de 1 µm (micromètre) à quelques micromètres, et tout particulièrement à rendre le procédé Smart Cut^{™} compatible avec le transfert de couches actives de grande épaisseur.

A cette fin, l'invention propose un procédé de fabrication d'un substrat donneur pour la réalisation d'une structure intégrée en trois dimensions, comprenant les étapes suivantes :
- fourniture d'un substrat semi-conducteur comprenant une couche superficielle, dite couche active, et une couche comprenant une pluralité de cavités s'étendant sous la couche active, chaque cavité étant séparée d'une cavité adjacente par une cloison,
- formation d'un dispositif électronique dans une région de la couche active située à l'aplomb d'une cavité,
- dépôt d'un masque de protection sur la couche active de sorte à recouvrir ledit dispositif électronique tout en exposant une région de la couche active située à l'aplomb de chaque cloison,
- implantation d'espèces atomiques au travers des régions de la couche active exposées par le masque, pour former une zone de fragilisation dans chaque cloison.

L'invention concerne également un procédé de fabrication d'une structure intégrée en trois dimensions, formée d'un empilement de couches actives munies de dispositifs électroniques, par transfert d'une couche d'un substrat donneur sur un substrat receveur, ledit procédé étant principalement caractérisé en ce qu'il comprend les étapes suivantes :
- fabrication du substrat donneur par le procédé de fabrication précédent,
- collage du substrat donneur sur le substrat receveur, la surface du substrat donneur opposée aux zones de fragilisation par rapport à la couche active à transférer étant à l'interface de collage,
- détachement du substrat donneur le long des zones de fragilisation afin de transférer au moins une partie de la couche active sur le substrat receveur.

Selon d'autres aspects, les procédés de fabrication précédents présentent les différentes caractéristiques suivantes, prises seules ou selon leurs combinaisons techniquement possibles :
- Préalablement à implantation d'espèces atomiques pour former une zone de fragilisation dans les cloisons, on met en œuvre une gravure sélective de la couche active pour retirer au moins une portion de la couche active située à l'aplomb d'une cloison ;
- On réalise en outre, préalablement à l'implantation d'espèces atomiques pour former une zone de fragilisation dans les cloisons, des tranchées s'étendant dans lesdites cloisons au-delà des cavités, de sorte à isoler au moins une cavité des autres cavités ;
- Avant le dépôt du masque de protection, on dépose une couche additionnelle formant une surépaisseur sur une portion de couche active située à l'aplomb de ladite cavité isolée ;
- Le détachement du substrat donneur est réalisé le long des zones de fragilisation formées par implantation d'espèces atomiques dans des parties de cloison résultant de la formation des tranchées, et la portion de couche active située à l'aplomb de la cavité isolée est transférée sélectivement sur le substrat receveur ;
- Le substrat semi-conducteur est fabriqué par la mise en œuvre des étapes suivantes :
   - réaliser une pluralité de cavités à la surface d'un substrat pour former la couche comprenant lesdites cavités,
   - transférer la couche active sur le substrat pour fermer les cavités ;
- Les cavités sont formées par gravure sèche et/ou gravure humide ;
- Les cavités sont creuses ;
- Les cavités sont formées par un traitement électrochimique ;
- Les cavités sont formées par la mise en œuvre des étapes suivantes :
   - dépôt d'un masque de protection sur une surface libre d'un substrat, le masque de protection étant disposé de manière à ménager des portions de surface couvertes et des portions de surface non couvertes,
   - implantation d'espèces atomiques dans le substrat à l'aplomb des portions de surface non couvertes par le masque de protection, des zones d'implantation en exposant la face du substrat recouverte du masque à un flux d'espèces atomiques incident,
   - réalisation d'un recuit thermique du substrat afin de former des cavités au niveau des zones d'implantation ;
- Chaque cavité est constituée d'un milieu poreux présentant une porosité supérieure ou égale à 20%, de préférence supérieure ou égale à 30%, par rapport au volume total de la cavité ;
- Le transfert de la couche active sur la couche comprenant les cavités est réalisé par la mise en œuvre des étapes suivantes :
   - implantation d'espèces atomiques pour former une zone de fragilisation dans un second substrat donneur en matériau semi-conducteur, afin de délimiter une couche en matériau semi-conducteur à transférer,
   - collage du second substrat donneur sur la couche comprenant les cavités du substrat donneur, la surface de la couche à transférer opposée à la zone de fragilisation par rapport à la couche à transférer étant à l'interface de collage,
   - détachement du second substrat donneur le long de la zone de fragilisation afin de transférer la couche en matériau semi-conducteur sur le substrat.

L'invention concerne également un substrat donneur comprenant une couche active destinée à être transférée sur un substrat receveur. Le substrat donneur est principalement caractérisé en ce qu'il comprend :
- une couche comprenant des cavités qui s'étendent dans l'épaisseur du substrat donneur et qui sont délimitées par des cloisons,
- une couche active située sur la couche comprenant les cavités, comprenant au moins un dispositif électronique, chaque dispositif électronique étant agencé dans une région de la couche active située à l'aplomb d'une cavité,
- des zones de fragilisation dans au moins une partie des cloisons séparant les cavités.

### DESCRIPTION DES FIGURES

D'autres avantages et caractéristiques de l'invention apparaîtront à la lecture de la description suivante donnée à titre d'exemple illustratif et non limitatif, en référence aux figures annexées qui représentent :
- La figure 1, une vue schématique en coupe d'un substrat de type « cavity silicon on insulator » (C-SOI) en anglais, c'est-à-dire un substrat de type SOI muni de cavités, selon un mode de réalisation, comprenant une couche comprenant des cavités sur laquelle est déposée une couche active ;
- La figure 2, une vue schématique en coupe du substrat de la figure 1, dans lequel ont été réalisés des dispositifs électroniques sur la couche active ;
- La figure 3, une vue schématique en coupe du substrat de la figure 1, dans lequel on réalise une implantation d'espèces atomiques pour former des zones de fragilisation, avec dépôt préalable d'un masque de protection sur les dispositifs électroniques de la couche active, pour former un substrat donneur ;
- La figure 4, une vue schématique du substrat donneur de la figure 3 avec une couche d'oxyde déposée sur la couche active ;
- La figure 5, une vue schématique illustrant l'alignement du substrat donneur avec un substrat receveur muni d'une couche active ;
- La figure 6, une vue schématique illustrant le collage du substrat donneur avec le substrat receveur ;
- La figure 7, une vue schématique illustrant le détachement du substrat donneur au niveau des zones de fragilisation ;
- La figure 8, une vue schématique d'une structure 3D de type semi-conducteur obtenue après retrait des résidus de détachement par gravure sélective.
- Les figures 9A, 9B, et 9C, des vues schématiques illustrant la fabrication selon un mode de réalisation d'une couche comprenant des cavités par gravure sur un substrat, et le dépôt d'une couche active sur la couche comprenant des cavités par un procédé Smart Cut^{™} ;
- Les figures 10A, 10B, et 10C, des vues schématiques illustrant la fabrication selon un mode de réalisation d'une couche comprenant des cavités par traitement électrochimique d'un substrat, et le dépôt d'une couche active sur la couche comprenant des cavités par un procédé Smart Cut^{™} ;
- Les figures 11A, 11B, et 11C, des vues schématiques illustrant la fabrication selon un mode de réalisation d'une couche comprenant des cavités par implantation d'espèces atomiques dans un substrat ;
- La figure 12, une vue schématique du substrat donneur illustrant, selon un mode de réalisation, la réalisation d'une gravure pour retirer sélectivement des portions de la couche active situées à l'aplomb des cloisons, puis l'implantation d'espèces atomiques dans le substrat gravé ;
- La figure 13, une vue schématique du substrat donneur illustrant, selon un mode de réalisation, la réalisation de tranchées dans les cloisons après gravure sélective, pour le transfert sélectif ultérieur d'un dispositif électronique déterminé de la couche active.

### DESCRIPTION DETAILLEE DE MODES DE REALISATION DE L'INVENTION

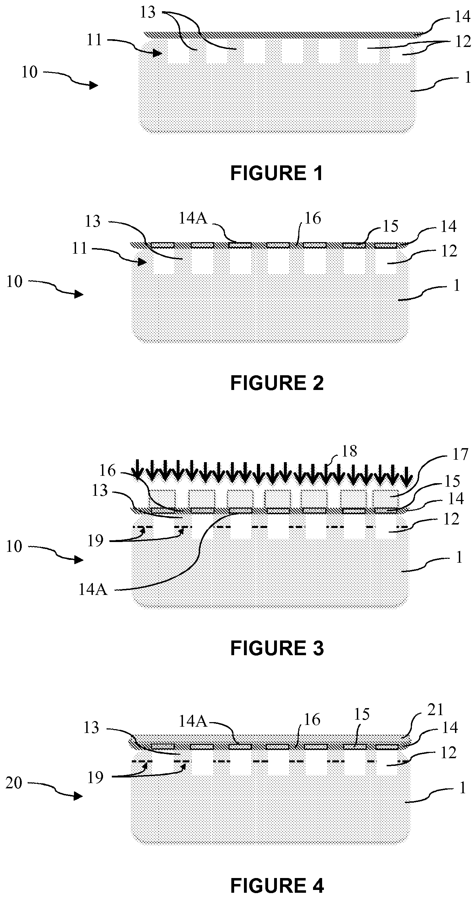

Un premier objet de l'invention concerne un procédé de fabrication d'un substrat donneur pour la réalisation d'une structure intégrée en trois dimensions. Le substrat donneur est obtenu à partir d'un substrat semi-conducteur dont un mode de réalisation est représenté sur la figure 1.

En référence à la figure 1, le substrat semi-conducteur 10 comprend un substrat 1, une couche 11 comprenant une pluralité de cavités 12, et une couche active 14 disposée sur la couche 11 comprenant les cavités de manière à recouvrir lesdites cavités 12.

Les cavités 12 sont des régions du substrat présentant une densité moindre que celle du reste du substrat. Lesdites cavités peuvent être creuses ou constituées d'un milieu poreux. Les cavités 12 s'étendent dans l'épaisseur du substrat 10 entre une première profondeur (correspondant, dans l'exemple illustré, à la surface supérieure du substrat 1) et une seconde profondeur plus grande, et sont séparées les unes des autres par des cloisons 13.

Le substrat 1, ou au moins la portion de substrat dans laquelle sont réalisées les cavités, est fabriqué dans un matériau semi-conducteur cristallin, tel que par exemple le silicium, le germanium, et leurs alliages, ainsi que les composés semi-conducteurs III/V comprenant par définition au moins un élément du groupe III et au moins un élément du groupe V de la classification périodique des éléments.

Les cavités 12 représentées schématiquement sur la figure 1 ont une section carrée ou rectangulaire dans un plan parallèle à la surface principale du substrat, et forment des volumes cubiques ou parallélépipédiques dans le substrat. On comprendra cependant que les cavités peuvent éventuellement se présenter sous d'autres formes.

Les cavités 12 sont séparées les unes des autres par les cloisons 13, qui correspondent à des portions du substrat 1 ayant une densité plus importante, par exemple la densité naturelle du matériau constituant le substrat 1. Les cloisons 13 ont donc une forme complémentaire à celle des cavités 12.

De préférence, les cavités ne débouchent pas sur la tranche du substrat, afin d'éviter toute amorce intempestive de fracture.

La couche active 14 est agencée sur la couche 11 comprenant les cavités et recouvre les cavités 12. En d'autres termes, les cavités 12 sont closes, chaque cavité étant délimitée dans le sens de l'épaisseur du substrat par une portion de la couche active 14 et par le substrat 1, et dans un sens parallèle à la surface exposée du substrat par deux cloisons adjacentes 13.

A partir du substrat semi-conducteur 10 décrit précédemment, on forme des dispositifs électroniques 15 dans des régions 14A de la couche active situées à l'aplomb des cavités 12, comme l'illustre la figure 2. De préférence, on forme de manière conventionnelle un dispositif électronique 15 dans chacune des régions 14A de la couche active située à l'aplomb d'une cavité 12 respective.

Les dispositifs électroniques 15 ne s'étendent en revanche pas dans les régions 16 situées à l'aplomb des cloisons 13.

Le fait de réaliser les dispositifs électroniques sur le substrat semi-conducteur (destiné à former le substrat donneur) avant de le coller sur le substrat receveur, permet de s'affranchir des contraintes limitant le budget thermique pour réaliser ces dispositifs électroniques, contrairement aux procédés connus de l'état de l'art dans lesquels les dispositifs électroniques ne sont réalisés qu'après transfert de la couche active sur un substrat receveur. En effet, dans les procédés connus de l'état de l'art, le budget thermique pour former les dispositifs électroniques sur la couche active transférée est limité afin de ne pas dégrader des dispositifs électroniques déjà présents dans ledit substrat receveur.

On procède ensuite au dépôt d'un masque de protection 17 sur la couche active. Cette étape est représentée sur la figure 3. Le masque de protection 17 est déposé de manière à recouvrir les dispositifs électroniques 15, tout en exposant les régions 16 de la couche active situées à l'aplomb des cloisons. Ainsi, les régions 14A de la couche active situées à l'aplomb des cavités comprennent un dispositif électronique 15 surmonté d'une portion de masque de protection 17.

Le masque de protection peut être une résine ou bien un masque solide, par exemple à base d'oxyde ou de nitrure.

Toujours en référence à la figure 3, on expose ensuite la surface du substrat sur laquelle a été déposé le masque à un flux 18 d'espèces atomiques.

Les espèces atomiques pénètrent dans le substrat 10 via les régions exposées de la couche active, et s'implantent dans les cloisons 13 sous-jacentes, à une profondeur déterminée par les paramètres d'implantation. Les espèces atomiques forment une zone de fragilisation 19 dans chaque cloison, et l'ensemble des zones de fragilisation, schématisées sur la figure 3 par des traits en pointillés, délimitent une couche superficielle destinée à être transférée ultérieurement sur un substrat receveur.

Les espèces atomiques qui rencontrent le masque de protection sont quant à elles bloquées par ledit masque et ne pénètrent pas dans le substrat.

De préférence, les espèces atomiques implantées sont des ions hydrogène et/ou des ions hélium.

L'homme du métier est en mesure de déterminer les paramètres d'implantation, notamment la nature des espèces atomiques, la dose et l'énergie des espèces, afin d'implanter les espèces atomiques à la profondeur souhaitée dans les cloisons.

Le fait que l'implantation soit réalisée après la formation des dispositifs électroniques dans la couche active permet d'éviter une fracture intempestive du substrat donneur le long des zones de fragilisation. En effet, la formation des dispositifs électroniques met en œuvre des budgets thermiques qui seraient susceptibles d'amorcer une fracture au niveau d'une zone de fragilisation formée au préalable.

On obtient ainsi, après retrait du masque, un substrat donneur 20 servant au transfert de la couche active 14 sur un substrat receveur, conformément au deuxième objet de l'invention décrit dans la suite.

Un deuxième objet de l'invention concerne un procédé de fabrication d'une structure intégrée en trois dimensions à partir d'un substrat donneur tel que décrit précédemment.

Une première étape optionnelle de ce procédé consiste à déposer une couche d'oxyde 21 sur la couche active 14 à transférer du substrat donneur 20, de manière à recouvrir les dispositifs électroniques 15. Le dépôt de la couche d'oxyde 21 est représenté sur la figure 4. Cette couche d'oxyde dite « couche d'oxyde enterrée » ou « buried oxide layer » (acronyme BOX) en anglais se trouve après collage ultérieur à l'interface de collage avec le substrat receveur. La couche d'oxyde permet d'améliorer le collage ultérieur du substrat donneur sur un substrat receveur. On peut également déposer une couche d'oxyde sur le substrat receveur, ou à la fois sur le substrat donneur et sur le substrat receveur. Le dépôt d'une couche d'oxyde à la fois sur le substrat donneur et sur le substrat receveur permet d'avoir un collage de type oxyde-oxyde, ce qui améliore encore davantage la qualité du collage.

Selon un mode de réalisation, les surfaces destinées à former l'interface de collage comportent des parties de différentes natures, afin de réaliser un collage dit hybride, par exemple un collage de type oxyde-métal. En effet, pour réaliser des interconnexions entre les dispositifs électroniques des couches empilées, on peut envisager des connexions qui débouchent sur la surface à l'interface de collage, notamment en oxyde. Ainsi, on peut avoir des parties d'interface de collage mixtes, telles que par exemple la combinaison des parties mixtes suivantes : oxyde-oxyde (Ox/Ox), métal-oxyde (Me/Ox), métal-métal (Me/Me), métal-oxyde (Me/Ox). Le métal est de préférence du cuivre.

Un lissage de la surface exposée de la couche d'oxyde 21 peut ensuite être effectué afin d'en réduire la rugosité et d'améliorer davantage la qualité du collage. Un lissage par polissage mécano-chimique (CMP, acronyme du terme anglo-saxon « Chemical Mechanical Polishing ») est particulièrement adapté à cet effet.

On procède ensuite au collage du substrat donneur 20 sur un substrat receveur 30.

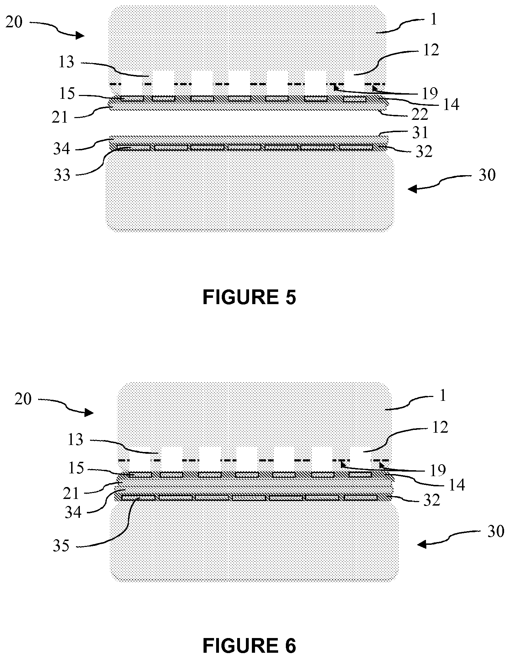

En référence à la figure 5, le substrat donneur 20 et le substrat receveur 30 sont d'abord positionnés en regard l'un de l'autre. Les surfaces destinées à former l'interface de collage, c'est-à-dire la surface libre 22 de la couche active du substrat donneur et la surface libre 31 du substrat receveur, sont parallèles.

Le substrat receveur 30 représenté sur la figure 5 comprend lui-même avantageusement une couche active 32, comprenant une pluralité de dispositifs électroniques 33. Cette couche active peut avoir été formée sur le substrat receveur pendant sa fabrication. Cette couche active peut avoir été déposée selon le présent procédé, lors d'un premier transfert, auquel cas la figure 5 illustre le transfert d'une seconde couche active 32 sur le substrat donneur 30, selon une seconde itération du procédé. Comme cela sera expliqué plus en détail dans la suite, le procédé vise en effet à déposer grâce au substrat donneur une pluralité de couches actives, ou portions de couches actives, sur le substrat receveur par itération ou répétition des étapes du procédé, afin de fabriquer une structure intégrée en trois dimensions.

En référence à la figure 6, le substrat donneur 20 est collé sur le substrat receveur 30. Les couches actives 14, 32 du substrat donneur et du substrat receveur, et le cas échéant les couches d'oxyde 21, 34 déposées l'une et ou l'autre de ces couches actives, forment l'interface de collage. De plus, la surface du substrat donneur opposée aux zones de fragilisation par rapport à la couche active à transférer se trouve à l'interface de collage.

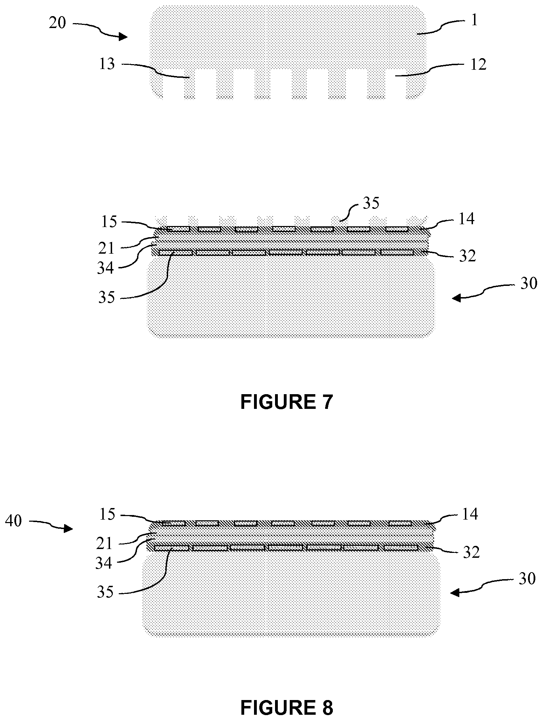

Le substrat donneur 20 est ensuite détaché le long des zones de fragilisation 19 et des cavités 12, ainsi que représenté sur la figure 7. A cet effet, on applique au substrat donneur une contrainte, par exemple thermique, qui initie puis propage une fracture au niveau des zones de fragilisation 19 et des cavités 12, qui sont par nature des zones de plus grande fragilité du substrat. La couche active 14 du substrat donneur est ainsi transférée sur le substrat receveur.

Après séparation, on conserve le substrat donneur 20 muni de sa couche comprenant des cavités. Le substrat donneur est dès lors réutilisable pour transférer d'autres couches actives sur le même substrat receveur 30, ou sur un substrat receveur différent, pour réaliser un empilement de couches actives et former une structure intégrée, par répétition des étapes décrites précédemment.

Etant donné que les cloisons 13 ont été fracturées, des fractions de cloisons 35 ont également été transférées avec la couche active sur le substrat receveur. Dès lors, la hauteur des cloisons 13 et respectivement la hauteur des cavités 12 du substrat donneur après transfert sont légèrement réduites, sans toutefois compromettre la réutilisation du substrat donneur.

On effectue donc de préférence un traitement de la surface libre de la couche active transférée afin de retirer les fractions de cloisons 35.

Lorsqu'une couche d'oxyde enterrée 21 a été déposée sur le substrat donneur avant collage, on traite la couche active transférée préférentiellement par gravure chimique afin de retirer les fractions de cloisons sans affecter la couche d'oxyde enterrée. Par exemple, une gravure chimique à base d'hydroxyde de tétraméthylammonium (TMAH) convient.

La structure finale 40 en trois dimensions obtenue est représentée sur la figure 8. Elle comprend le substrat receveur 30 ainsi qu'un empilement de deux couches actives 14, 32, chacune munie de dispositifs électroniques.

Le substrat donneur peut ensuite être réutilisé pour effectuer le transfert d'une nouvelle couche active sur le substrat receveur. Pour ce faire, on forme une nouvelle couche active sur le substrat donneur qui vient recouvrir les cavités, puis on répète les étapes de formation des dispositifs électroniques sur la couche active, optionnellement dépôt d'une couche d'oxyde, dépôt d'un masque de protection sur les dispositifs électroniques, implantation d'espèces atomiques dans les cloisons, collage, et détachement du substrat donneur.

La couche active 14 est de préférence transférée depuis un second substrat donneur sur la couche comprenant les cavités du substrat semi-conducteur, selon le procédé Smart Cut^{™} (non représenté).

En détail, on procède à une implantation d'espèces atomiques pour former une zone de fragilisation dans le second substrat donneur, afin de délimiter la couche active à transférer.

On colle ensuite le second substrat donneur sur la couche comprenant les cavités du substrat. Lors du collage, la surface de la couche active à transférer opposée à la zone de fragilisation par rapport à la couche à transférer se trouve à l'interface de collage.

Le second substrat donneur est ensuite détaché le long de la zone de fragilisation afin de transférer la couche active sur le substrat.

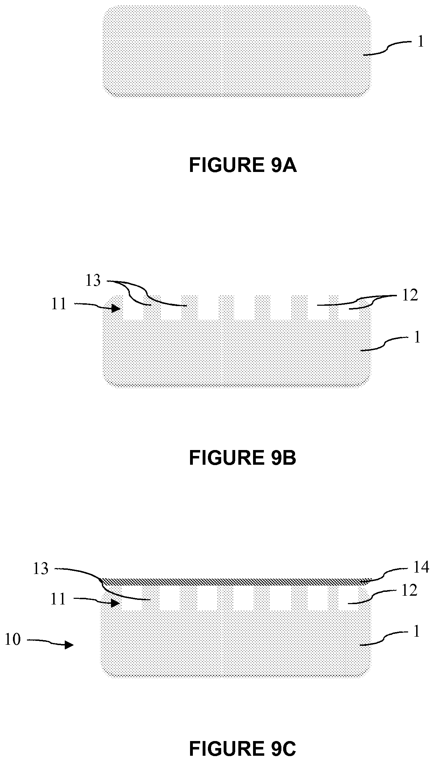

Les cavités 12 du substrat donneur sont de préférence formées selon les modes de réalisation décrits dans la suite en référence aux figures 9A-C, 10A-C, et 11A-C.

Selon un premier mode de réalisation, les cavités 12 sont formées dans le substrat 1 représenté sur la figure 9A par gravure sèche et/ou gravure humide. On obtient le substrat de la figure 9B comprenant une couche 11 munie de cavités 12.

La gravure permet d'obtenir des cavités creuses. La gravure présente l'avantage d'être couramment utilisée dans le domaine de la fabrication des structures semiconductrices, de sorte que sa mise en œuvre est relativement simple. On précise que d'autres techniques que la gravure peuvent convenir à condition qu'elles permettent de former des cavités creuses.

La formation des cavités 12 est suivie du transfert de la couche active 14 de manière à recouvrir les cavités, ainsi que représenté sur la figure 9C. Le transfert de la couche active est de préférence réalisé selon le procédé Smart Cut^{™} décrit précédemment.

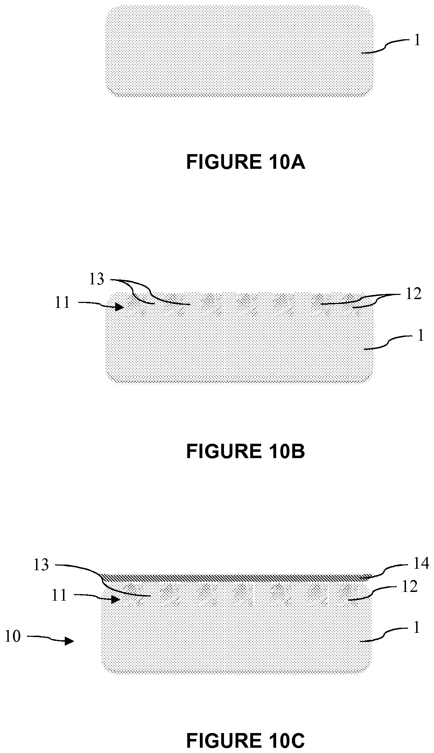

Selon un deuxième mode de réalisation, les cavités 12 sont formées dans le substrat 1 représenté sur la figure 10A par un traitement électrochimique. On obtient le substrat de la figure 10B comprenant une couche 11 munie de cavités 12.

Un tel traitement consiste à former localement des porosités par application d'un courant électrique, et est couramment désigné par « electro-porosification » selon la terminologie anglo-saxonne.

Ce traitement électrochimique permet d'obtenir des cavités constituées d'un milieu poreux. La porosité des cavités formées est de préférence supérieure ou égale à 20%, et de manière davantage préférée supérieure ou égale à 30%, par rapport au volume total de la cavité.

La formation des cavités 12 est suivie du transfert de la couche active 14 de manière à recouvrir les cavités, ainsi que représenté sur la figure 10C. Le transfert de la couche active est de préférence réalisé selon le procédé Smart Cut^{™} décrit précédemment.

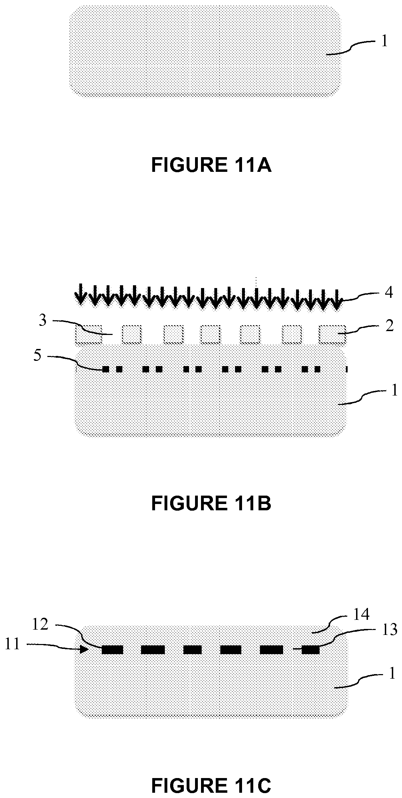

Selon un troisième mode de réalisation, les cavités 12 sont formées dans le substrat 1 représenté sur la figure 11A par implantation d'espèces atomiques dans ledit substrat.

On commence par déposer un masque de protection 2 sur une surface libre du substrat. Le masque ménage des portions de surface couvertes et des portions de surface non couvertes 3.

On expose ensuite la face du substrat recouverte par le masque à un flux d'espèces atomiques incident 4, afin d'implanter des espèces atomiques dans le substrat. Il s'agit de préférence d'un flux d'ions hydrogène et/ou d'ions hélium.

Les espèces atomiques pénètrent dans le substrat via les régions non couvertes 3 par le masque, et s'implantent à l'aplomb desdites zones non couvertes. Les espèces atomiques implantées dans le substrat sont représentées sur la figure 11B par des traits en pointillés 5. Les espèces atomiques forment des zones d'implantation, espacées les unes des autres, chaque zone d'implantation étant destinée à former une cavité.

Les espèces atomiques qui rencontrent le masque de protection sont quant à elles bloquées par ledit masque et ne pénètrent pas dans le substrat.

L'homme du métier est en mesure de déterminer les paramètres d'implantation, notamment la nature des espèces atomiques, la dose et l'énergie des espèces, afin d'implanter les espèces atomiques dans le substrat, à la profondeur souhaitée.

On procède ensuite à un recuit du substrat afin de développer les défauts (« platelets » selon la terminologie anglo-saxonne) créés par l'implantation pour former des cavités 12 au niveau des zones d'implantation. Le substrat ainsi obtenu est représenté sur la figure 11C. Les cavités 12 sont séparées les unes des autres par les cloisons 13 situées à l'aplomb des portions de surface 3 qui n'étaient pas couvertes par le masque de lithographie 2.

Contrairement aux premier et deuxième modes de réalisation, la couche active est définie comme étant la couche superficielle 14 délimitée par la couche 11 contenant les cavités (cf. figure 11C). Ce troisième mode de réalisation ne fait donc pas intervenir de transfert de la couche active sur la couche munie de cavités pour fabriquer le substrat donneur. Ceci permet de s'affranchir d'une étape de fabrication et ainsi de réduire le temps de fabrication du substrat donneur.

Optionnellement, on procède ensuite au dépôt d'une couche d'oxyde, telle que décrite précédemment, sur la couche active de manière à recouvrir les dispositifs électroniques, afin d'améliorer le collage.

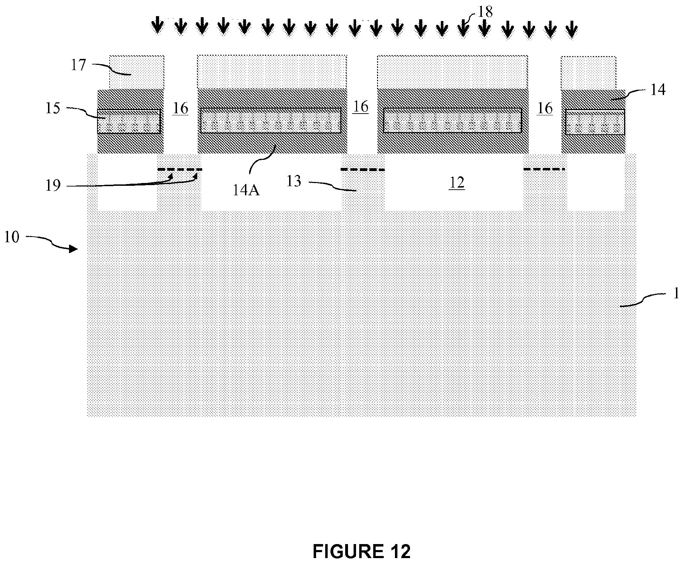

Selon un mode de réalisation représenté sur la figure 12, on réalise une gravure sélective de la couche active 14, afin de retirer des portions de couches actives situées à l'aplomb des cloisons. Cette gravure est réalisée préalablement à la formation des zones de fragilisation dans les cloisons par implantation d'espèces atomiques.

Une telle gravure sélective permet de rendre davantage accessibles les cloisons au flux incident et améliore l'implantation des espèces atomiques dans les cloisons ainsi que la faisabilité de la fracturation des cloisons lors du détachement du substrat donneur. En effet, les espèces atomiques pénètrent ainsi dans le substrat via les portions évidées 23 situées à l'aplomb des cloisons 13, sans traverser la couche active 14.

Ce mode de réalisation est particulièrement avantageux lorsque la couche active a une épaisseur importante, c'est-à-dire de 1 µm (micromètre) à quelques micromètres, ce qui a tendance à limiter l'implantation. Grâce à ces évidements, l'implantation des espèces atomiques n'est plus limitée par l'épaisseur de la couche active.

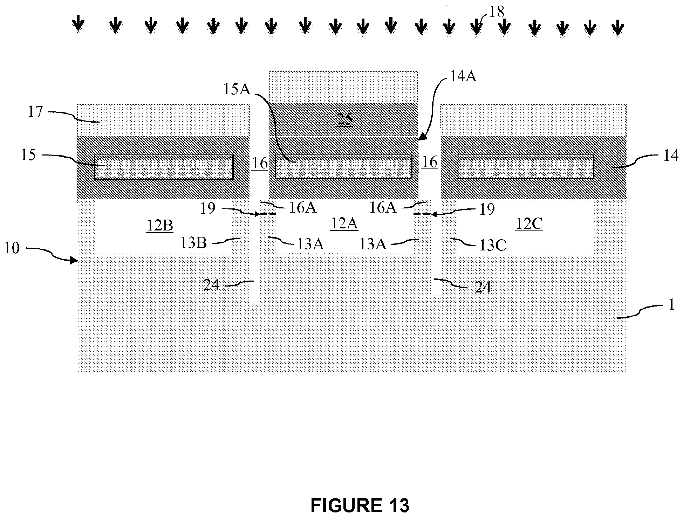

Selon un mode de réalisation représenté sur la figure 13, on réalise en outre des tranchées 24 dans au moins une partie des cloisons 13, préalablement à la formation des zones de fragilisation dans les cloisons.

Les tranchées 24 s'étendent dans l'épaisseur du substrat au-delà des cavités 12, c'est-à-dire plus profondément que les cavités.

Les tranchées 24 permettent d'isoler une cavité déterminée, et donc en particulier, un dispositif électronique déterminé situé à l'aplomb de ladite cavité, afin de permettre ultérieurement son transfert sélectif sur le substrat receveur.

Une tranchée 24 sépare une cloison en deux portions 13A, 13B, dont une première portion délimite une première cavité 12A à l'aplomb de laquelle se trouve un dispositif électronique, et une deuxième portion délimite une deuxième cavité 12B adjacente à la première cavité, à l'aplomb de laquelle se trouve un autre dispositif électronique.

Les tranchées sont réalisées tout autour de la portion de couche active à transférer, dans les cloisons correspondantes. Par exemple, dans le cas d'une cavité cubique comme les cavités 12A, 12B, et 12C, ladite cavité est délimitée par quatre cloisons, et chacune des cloisons est percée d'une tranchée.

En référence à la figure 13, des tranchées 24 sont réalisées dans les cloisons 13 qui délimitent la cavité 12A, à l'aplomb de laquelle se trouve la portion 14A de couche active à transférer avec son dispositif électronique 15A. Deux tranchées seulement sont représentées sur la figure 13 car les deux autres cloisons qui délimitent la cavité 12A ne sont pas visibles sur la figure 13.

Les portions de cloison 13A qui délimitent la portion 12A de couche active à transférer dépassent latéralement de ladite portion de couche active, le dépassement étant légendé selon la référence 16A sur la figure 13, et se trouvent partiellement alignées avec les portions de couche active gravées précédemment.

Les autres portions de cloisons 13B, 13C, qui délimitent des portions de couche active 14B, 14C adjacentes à la portion de couche active à transférer 14A, quant à elles ne dépassent pas de leur portion de couche active respective 14B, 14C.

Ainsi, lors de l'étape d'implantation des espèces atomiques, les portions de cloison 13A qui délimitent la portion de couche active à transférer 14A sont exposées au flux incident. Les espèces atomiques s'implantent alors dans lesdites portions de cloison exposées.

Les autres portions de cloisons 13B, 13C qui délimitent des portions de couche active 14B, 14C adjacentes à la portion de couche active à transférer quant à elles ne sont pas exposées au flux incident, de sorte que les espèces atomiques ne s'y implantent pas.

On forme ainsi des zones de fragilisation 19 dans chacune des portions de cloison délimitant la portion de couche active 14A à transférer.

On procède ensuite au collage du substrat donneur sur le substrat receveur, puis au détachement de la portion de couche active 14A déterminée le long des zones de fragilisation 19 des portions de cloison 13A, ce qui permet de transférer de manière sélective la portion de couche active 14A sur le substrat receveur, tandis que le reste de la couche active 14 demeure sur le substrat donneur.

La description de ce transfert sélectif faite en référence à la figure 13 concerne le transfert d'une seule portion de couche active. Il doit être cependant compris que plusieurs portions déterminées de couche active peuvent être transférées sélectivement, en réalisant un ou plusieurs transferts successifs, afin de transférer les dispositifs électroniques souhaités sur le substrat receveur, ou sur plusieurs substrats receveurs différents à partir du même substrat donneur.

Selon un mode de réalisation préféré, on dépose une couche additionnelle 25 sur la portion de couche active 14A à transférer, préalablement au dépôt du masque de protection, afin de former une surépaisseur. La couche additionnelle se trouve alors entre la portion de couche active et le masque de protection.

Après retrait du masque, et optionnellement dépôt d'une couche d'oxyde sur la couche active et traitement de surface, préférablement par CMP, la portion de couche active 14A avec surépaisseur 25 est transférée sur le substrat receveur 30.

La formation d'une surépaisseur 25 permet d'individualiser davantage la ou les portions de couche active à transférer, et ainsi d'en simplifier le transfert. En effet, lors du collage, seules les portions de couche active surélevées viennent au contact du substrat receveur. Un simple détachement du substrat donneur par fracturation des portions de cloison correspondantes permet de transférer les dispositifs électroniques souhaités sur le substrat receveur, tandis que les autres portions de couche active restent à distance du substrat receveur, et demeurent sur le substrat donneur.

Il est ensuite possible de déposer une couche additionnelle sur une ou plusieurs des portions de couche active restantes sur le substrat donneur pour former des surépaisseurs, de manière à transférer lesdites portions restantes sur un autre substrat receveur.

Le procédé décrit permet donc de transférer sélectivement des dispositifs électroniques d'un substrat donneur sur un ou plusieurs substrats receveurs différents, en réutilisant le même substrat donneur.

## Revendications

1. Procédé de fabrication d'un substrat donneur (20) pour la réalisation d'une structure intégrée en trois dimensions (40), comprenant les étapes suivantes :
- fourniture d'un substrat semi-conducteur (10) comprenant une couche superficielle (14), dite couche active, et une couche (11) comprenant une pluralité de cavités (12) s'étendant sous la couche active, chaque cavité (12) étant séparée d'une cavité adjacente par une cloison (13),
- formation d'un dispositif électronique (15) dans une région (14A) de la couche active (14) située à l'aplomb d'une cavité (12),
- dépôt d'un masque de protection (17) sur la couche active (14) de sorte à recouvrir ledit dispositif électronique (15) tout en exposant une région (16) de la couche active située à l'aplomb de chaque cloison (13),
- implantation d'espèces atomiques au travers des régions de la couche active exposées par le masque, pour former une zone de fragilisation (19) dans chaque cloison (13).

2. Procédé de fabrication d'une structure intégrée en trois dimensions (40), formée d'un empilement de couches actives (14) munies de dispositifs électroniques (15), par transfert d'une couche d'un substrat donneur (20) sur un substrat receveur (30), ledit procédé étant **caractérisé en ce qu'**il comprend les étapes suivantes :
- fabrication du substrat donneur (20) par le procédé de fabrication selon la revendication 1,
- collage du substrat donneur (20) sur le substrat receveur (30), la surface du substrat donneur opposée aux zones de fragilisation (19) par rapport à la couche active (14) à transférer étant à l'interface de collage,
- détachement du substrat donneur (20) le long des zones de fragilisation (19) afin de transférer au moins une partie de la couche active (14) sur le substrat receveur (30).

3. Procédé selon l'une des revendications 1 ou 2, dans lequel, préalablement à implantation d'espèces atomiques pour former une zone de fragilisation (19) dans les cloisons (13), on met en œuvre une gravure sélective de la couche active (14) pour retirer au moins une portion de la couche active située à l'aplomb d'une cloison (13).

4. Procédé selon la revendication 3, dans lequel on réalise en outre, préalablement à l'implantation d'espèces atomiques pour former une zone de fragilisation (19) dans les cloisons (13), des tranchées (24) s'étendant dans lesdites cloisons (13) au-delà des cavités (12), de sorte à isoler au moins une cavité (12) des autres cavités.

5. Procédé selon la revendication 4 dans lequel, avant le dépôt du masque de protection (17), on dépose une couche additionnelle (25) formant une surépaisseur sur une portion de couche active (14A) située à l'aplomb de ladite cavité isolée (12A).

6. Procédé selon la revendication 2 en combinaison avec la revendication 4 ou la revendication 5, dans lequel le détachement du substrat donneur (20) est réalisé le long des zones de fragilisation (19) formées par implantation d'espèces atomiques dans des parties de cloison (13A) résultant de la formation des tranchées (24), et la portion de couche active (14A) située à l'aplomb de la cavité isolée (12A) est transférée sélectivement sur le substrat receveur (30).

7. Procédé selon l'une quelconque des revendications précédentes, dans lequel le substrat semi-conducteur (10) est fabriqué par la mise en œuvre des étapes suivantes :
- réaliser une pluralité de cavités (12) à la surface d'un substrat (1) pour former la couche (11) comprenant lesdites cavités (12),
- transférer la couche active (14) sur le substrat (1) pour fermer les cavités (12).

8. Procédé selon l'une des revendications 1 ou 7, dans lequel les cavités (12) sont formées par gravure sèche et/ou gravure humide.

9. Procédé selon l'une des revendications 1, 7, ou 8, dans lequel les cavités (12) sont creuses.

10. Procédé selon l'une des revendications 1 ou 7, dans lequel les cavités (12) sont formées par un traitement électrochimique.

11. Procédé selon la revendication 1, dans lequel les cavités (12) sont formées par la mise en oeuvre des étapes suivantes :
- dépôt d'un masque de protection (2) sur une surface libre d'un substrat (1), le masque de protection étant disposé de manière à ménager des portions de surface couvertes et des portions de surface non couvertes (3),
- implantation d'espèces atomiques dans le substrat à l'aplomb des portions de surface non couvertes (3) par le masque de protection, des zones d'implantation (5) en exposant la face du substrat recouverte du masque à un flux d'espèces atomiques incident,
- réalisation d'un recuit thermique du substrat (1) afin de former des cavités (12) au niveau des zones d'implantation (5).

12. Procédé selon l'une des revendications 1, 10 ou 11, dans lequel chaque cavité (12) est constituée d'un milieu poreux présentant une porosité supérieure ou égale à 20%, de préférence supérieure ou égale à 30%, par rapport au volume total de la cavité.

13. Procédé selon la revendication 7, dans lequel le transfert de la couche active (14) sur la couche (11) comprenant les cavités est réalisé par la mise en œuvre des étapes suivantes :
- implantation d'espèces atomiques pour former une zone de fragilisation dans un second substrat donneur en matériau semi-conducteur, afin de délimiter une couche en matériau semi-conducteur à transférer,
- collage du second substrat donneur sur la couche (11) comprenant les cavités du substrat donneur, la surface de la couche à transférer opposée à la zone de fragilisation par rapport à la couche à transférer étant à l'interface de collage,
- détachement du second substrat donneur le long de la zone de fragilisation afin de transférer la couche en matériau semi-conducteur sur le substrat.

14. Substrat donneur (10) comprenant une couche active (14) destinée à être transférée sur un substrat receveur (20), **caractérisé en ce qu'**il comprend :
- une couche (11) comprenant des cavités (12) qui s'étendent dans l'épaisseur du substrat donneur (10) et qui sont délimitées par des cloisons (13),
- une couche active (14) située sur la couche (11) comprenant les cavités, comprenant au moins un dispositif électronique (15), chaque dispositif électronique étant agencé dans une région (14A) de la couche active située à l'aplomb d'une cavité,
- des zones de fragilisation (19) dans au moins une partie des cloisons (13) séparant les cavités (12).

## Patentansprüche

1. Verfahren zur Herstellung eines Donorsubstats (20) für die Fertigung einer dreidimensionalen integrierten Struktur (40), das die folgenden Schritte umfasst:
- Liefern eines Halbleitersubstrats (10), das eine aktive Schicht genannte Oberflächenschicht (14) und eine Schicht (11) umfasst, die eine Vielzahl von Kavitäten (12) umfasst, die sich unter der aktiven Schicht erstrecken, wobei jede Kavität (12) durch eine Trennwand (13) von einer benachbarten Kavität getrennt ist,
- Bilden einer elektronischen Vorrichtung (15) in einer Region (14A) der aktiven Schicht (14), die sich senkrecht zu einer Kavität (12) befindet,
- Abscheiden einer Schutzmaske (17) auf der aktiven Schicht (14), derart dass die elektronische Vorrichtung (15) bedeckt wird und dabei eine Region (16) der aktiven Schicht, die sich senkrecht zu jeder Trennwand (13) befindet, freiliegt,
- Implantation von Atomspezies durch Regionen der aktiven Schicht, die durch die Maske freiliegen, um eine Schwächungszone (19) in jeder Trennwand (13) zu bilden.

2. Verfahren zur Herstellung einer dreidimensionalen integrierten Struktur (40), die aus einer Stapelung von aktiven Schichten (14) gebildet wird, die mit elektronischen Vorrichtungen (15) versehen sind, durch Übertragen einer Schicht eines Donorsubstrats (20) auf ein Empfängersubstrat (30), wobei das Verfahren **dadurch gekennzeichnet ist, dass** es die folgenden Schritte umfasst:
- Herstellung eines Donorsubstrats (20) durch das Herstellungsverfahren nach Anspruch 1,
- Kleben des Donorsubstrats (20) auf das Empfängersubstrat (30), wobei die Oberfläche des Donorsubstrats, die den Schwächungszonen (19) in Bezug auf die zu übertragende aktive Schicht (14) entgegengesetzt ist, sich an der Klebegrenzfläche befindet,
- Lösen des Donorsubstrats (20) entlang der Schwächungszonen (19), um zumindest einen Teil der aktiven Schicht (14) auf das Empfängersubstrat (30) zu übertragen.

3. Verfahren nach einem der Ansprüche 1 oder 2, wobei vor der Implantation von Atomspezies zum Bilden einer Schwächungszone (19) in den Wänden (13) ein selektives Ätzen der aktiven Schicht (14) durchgeführt wird, um zumindest einen Abschnitt der aktiven Schicht, der sich senkrecht zu einer Trennwand (13) befindet, zu entfernen.

4. Verfahren nach Anspruch 3, wobei ferner vor der Implantation von Atomspezies zum Bilden einer Schwächungszone (19) in den Trennwänden (13) Gräben (24) gefertigt werden, die sich in den Trennwänden (13) über die Kavitäten (12) hinaus erstrecken, derart dass mindestens eine Kavität (12) von den anderen Kavitäten isoliert wird.

5. Verfahren nach Anspruch 4, wobei vor dem Abscheiden der Schutzmaske (17) eine zusätzliche Schicht (25) abgeschieden wird, die auf einem Abschnitt der aktiven Schicht (14A), der sich senkrecht zu der isolierten Kavität (12A) befindet, eine Überdicke bildet.

6. Verfahren nach Anspruch 2 in Kombination mit Anspruch 4 oder Anspruch 5, wobei die Ablösung des Donorsubstrats (20) entlang der Schwächungszonen (19) ausgeführt wird, die durch Implantation von Atomspezies in den Trennwandteilen (13A) gebildet wurden, die sich aus der Bildung der Gräben (24) ergeben, und der Abschnitt der aktiven Schicht (14A), der sich senkrecht zu der isolierten Kavität (12A) befindet, selektiv auf das Empfängersubstrat (30) übertragen wird.

7. Verfahren nach einem der vorhergehenden Ansprüche, wobei das Halbleitersubstrat (10) durch Durchführen der folgenden Schritte gefertigt wird:
- Herstellen einer Vielzahl von Kavitäten (12) auf der Oberfläche eines Substrats (1), um die Schicht (11) zu bilden, die die Kavitäten (12) umfasst,
- Übertragen der aktiven Schicht (14) auf das Substrat (1), um die Kavitäten (12) zu schließen.

8. Verfahren nach einem der Ansprüche 1 bis 7, wobei die Kavitäten (12) durch Trockenätzen und/oder Nassätzen gebildet werden.

9. Verfahren nach einem der Ansprüche 1, 7 oder 8, wobei die Kavitäten (12) hohl sind.

10. Verfahren nach einem der Ansprüche 1 bis 7, wobei die Kavitäten (12) durch eine elektrochemische Behandlung gebildet werden.

11. Verfahren nach Anspruch 1, wobei die Kavitäten (12) durch die Durchführung der folgenden Schritte gebildet werden:
- Abscheiden einer Schutzmaske (2) auf einer freien Oberfläche eines Substrats (1), wobei die Schutzmaske derart angeordnet wird, dass bedeckte Oberflächenabschnitte und nicht bedeckte Oberflächenabschnitte (3) vorgesehen werden,
- Implantation von Atomspezies in dem Substrat senkrecht zu den nicht von der Schutzmaske bedeckten Oberflächenabschnitten (3) der Implantationszonen (5), indem die Seite des Substrats, die von der Maske bedeckt ist, einer einfallenden Strömung von Atomspezies ausgesetzt wird,
- Ausführen eines thermischen Glühens des Substrats (1), um Kavitäten (12) im Bereich der Implantationszonen (5) zu bilden.

12. Verfahren nach einem der Ansprüche 1, 10 oder 11, wobei jede Kavität (12) aus einem porösen Medium besteht, das eine Porosität von größer oder gleich 20 %, vorzugsweise größer oder gleich 30 %, bezogen auf das Gesamtvolumen der Kavität aufweist.

13. Verfahren nach Anspruch 7, wobei die Übertragung der aktiven Schicht (14) auf die Schicht (11), die die Kavitäten umfasst, durch das Durchführen der folgenden Schritte ausgeführt wird:
- Implantation von Atomspezies zum Bilden einer Schwächungszone in einem zweiten Donorsubstrat aus Halbleitermaterial, um eine zu übertragende Schicht aus Halbleitermaterial abzugrenzen,
- Kleben des zweiten Donorsubstrats auf die Schicht (11), die die Kavitäten des Donorsubstrats umfasst, wobei die Oberfläche der zu übertragenen Schicht, die der Schwächungszone in Bezug auf die zu übertragende Schicht entgegengesetzt ist, sich an der Klebegrenzfläche befindet,
- Ablösen des zweiten Donorsubstrats entlang der Schwächungszone, um die Schicht aus Halbleitermaterial auf das Substrat zu übertragen.

14. Donorsubstrat (10), das eine aktive Schicht (14) umfasst, die dazu bestimmt ist, auf ein Empfängersubstrat (20) übertragen zu werden, **dadurch gekennzeichnet, dass** es umfasst:
- eine Schicht (11), die Kavitäten (12) umfasst, die sich in der Dicke des Donorsubstrats (10) erstrecken und die durch Trennwände (13) abgegrenzt sind,
- eine aktive Schicht (14), die sich auf der Schicht (11) befindet, die die Kavitäten umfasst und mindestens eine elektronische Vorrichtung (15) umfasst, wobei jede elektronische Vorrichtung in einer Region (14A) der aktiven Schicht eingerichtet ist, die sich senkrecht zu einer Kavität befindet,
- Schwächungszonen (19) in mindestens einem Teil der Trennwände (13), die die Kavitäten (12) trennen.

## Claims

1. Process for fabricating a donor substrate (20) for the production of a three-dimensional integrated structure (40), comprising the following steps:
- providing a semiconductor substrate (10) comprising a surface layer (14), referred to as an active layer, and a layer (11) containing a plurality of cavities (12) extending beneath the active layer, each cavity (12) being separated from an adjacent cavity by a wall (13),
- forming an electronic device (15) in a region (14A) of the active layer (14) located plumb with a cavity (12),
- depositing a protective mask (17) on the active layer (14) so as to cover said electronic device (15) while exposing a region (16) of the active layer located plumb with each wall (13),
- implanting atomic species through the regions of the active layer exposed by the mask, to form a weakened zone (19) in each wall (13).

2. Process for fabricating a three-dimensional integrated structure (40), formed of a stack of active layers (14) provided with electronic devices (15), by transfer of a layer from a donor substrate (20) to a receiver substrate (30), said process being **characterized in that** it comprises the following steps:
- fabricating the donor substrate (20) by the fabrication process according to claim 1,
- bonding the donor substrate (20) to the receiver substrate (30), the surface of the donor substrate opposite the weakened zones (19) relative to the active layer (14) to be transferred being at the bonding interface,
- detaching the donor substrate (20) along the weakened zones (19) in order to transfer at least one portion of the active layer (14) to the receiver substrate (30).

3. Process according to one of claims 1 or 2, wherein, prior to implantation of atomic species to form a weakened zone (19) in the walls (13), a selective etching of the active layer (14) is carried out to remove at least one portion of the active layer located plumb with a wall (13).

4. Process according to claim 3, wherein, prior to the implantation of atomic species to form a weakened zone (19) in the walls (13), trenches (24) that extend in said walls (13) beyond the cavities (12) are further produced so as to isolate at least one cavity (12) from the other cavities.

5. Process according to claim 4 wherein, before the deposition of the protective mask (17), an additional layer (25) is deposited that forms an excess thickness on an active layer portion (14A) located plumb with said isolated cavity (12A).

6. Process according to claim 2 in combination with claim 4 or claim 5, wherein the detachment of the donor substrate (20) is carried out along the weakened zones (19) formed by implantation of atomic species in wall parts (13A) resulting from the formation of the trenches (24), and the active layer portion (14A) located plumb with the isolated cavity (12A) is selectively transferred to the receiver substrate (30).

7. Process according to any one of the preceding claims, wherein the semiconductor substrate (10) is fabricated by the implementation of the following steps:
- producing a plurality of cavities (12) at the surface of a substrate (1) to form the layer (11) containing said cavities (12),
- transferring the active layer (14) to the substrate (1) to seal the cavities (12).

8. Process according to one of claims 1 or 7, wherein the cavities (12) are formed by dry etching and/or wet etching.

9. Process according to one of claims 1, 7 or 8, wherein the cavities (12) are hollow.

10. Process according to one of claims 1 or 7, wherein the cavities (12) are formed by an electrochemical treatment.

11. Process according to claim 1, wherein the cavities (12) are formed by the implementation of the following steps:
- depositing a protective mask (2) on a free surface of a substrate (1), the protective mask being positioned so as to make covered surface portions and uncovered surface portions (3),
- implanting atomic species in the substrate plumb with the surface portions (3) not covered by the protective mask, of the implantation zones (5) by exposing the face of the substrate covered with the mask to an incident flux of atomic species,
- carrying out a thermal annealing of the substrate (1) in order to form cavities (12) at the implantation zones (5).

12. Process according to one of claims 1, 10 or 11, wherein each cavity (12) consists of a porous medium having a porosity greater than or equal to 20%, preferably greater than or equal to 30%, relative to the total volume of the cavity.

13. Process according to claim 7, wherein the active layer (14) is transferred to the cavity-containing layer (11) by the implementation of the following steps:
- implanting atomic species to form a weakened zone in a second donor substrate made of semiconductor material, in order to delimit a layer of semiconductor material to be transferred,
- bonding the second donor substrate to the cavity-containing layer (11) of the donor substrate, the surface of the layer to be transferred opposite the weakened zone relative to the layer to be transferred being at the bonding interface,
- detaching the second donor substrate along the weakened zone in order to transfer the layer of semiconductor material to the substrate.

14. Donor substrate (10) comprising an active layer (14) intended to be transferred to a receiver substrate (20), **characterized in that** it comprises:
- a layer (11) containing cavities (12) which extend in the thickness of the donor substrate (10) and which are delimited by walls (13),
- an active layer (14) located on the cavity-containing layer (11), comprising at least one electronic device (15), each electronic device being arranged in a region (14A) of the active layer located plumb with a cavity,
- weakened zones (19) in at least one part of the walls (13) separating the cavities (12).
